# EUROPÄISCHE PATENTSCHRIFT

(11) **EP 3 110 745 B1**
(45) Veröffentlichungstag und Bekanntmachung des Hinweises auf die Patenterteilung: **20.12.2017**
(21) Anmeldenummer: 15704213.6
(22) Anmeldetag: 11.02.2015
(51) Int. Cl.: B81B 3/00

(54) **VERFAHREN ZUR HERSTELLUNG EINES BAUTEILS**
METHOD FOR PRODUCING A COMPONENT
PROCÉDÉ DE PRODUCTION D'UNE PIÈCE

(30) Priorität: 25.02.2014 DE 102014002824
(43) Veröffentlichungstag der Anmeldung: 04.01.2017
(73) Patentinhaber: Northrop Grumman LITEF GmbH, 79115 Freiburg (DE)
(72) Erfinder: GEIGER, Wolfram, 72116 Mössingen (DE); BRENG, Uwe, 79194 Gundelfingen (DE); HAFEN, Martin, 68740 Rustenhart (FR); SPAHLINGER, Günter, 70188 Stuttgart (DE)
(74) Vertreter: Müller Hoffmann & Partner
(86) Internationale Anmeldenummer: PCT/EP2015/000305
(87) Internationale Veröffentlichungsnummer: WO 2015/128064

(56) Entgegenhaltungen:
- EP-A1- 1 663 850
- DE-A1-102005 015 584
- DE-A1-102007 030 121

## Beschreibung

Die Erfindung bezieht sich auf ein Verfahren zur Herstellung eines Bauteils, insbesondere eines mikromechanischen, mikro-elektromechanischen (MEMS) bzw. mikro-opto-elektromechanischen (MOEMS) Bauteils.

Mikro-elektromechanische Bauteile (MEMS) bzw. mikro-opto-elektromechanische Bauteile (MOEMS) umfassen häufig aktive Strukturen. Unter "aktiver Struktur" sind hier insbesondere bewegliche Strukturen oder Strukturen, die gleichermaßen bewegliche und optische Komponenten aufweisen (z.B. bewegliche Spiegel) zu verstehen. Der Begriff "aktives Gebiet" bezeichnet das Gebiet bzw. Volumen des Bauteils, in dem die aktive Struktur liegt bzw. sich bewegt. Dabei kann es notwendig oder vorteilhaft sein, wenn die aktive Struktur nicht aus einem einheitlichen Verbund besteht, sondern mindestens zwei getrennte Teile oder Bereiche aufweist, die zwar mechanisch starr miteinander verbunden, aber vollständig elektrisch isoliert voneinander sind.

Das Ausbilden einer elektrischen Isolation zwischen den voneinander elektrisch isolierten Teilen der aktiven Struktur stellt dabei eine besondere Herausforderung bei der Herstellung eines solchen Bauteils dar, da die aktive Struktur nur in geringem Maße mit anderen Elementen des Bauteils physisch verbunden ist, um ihre Beweglichkeit zu gewährleisten.

Es ist daher die Aufgabe der Erfindung, ein Verfahren zum Herstellen eines Bauteils, insbesondere eines mikromechanischen, mikro-elektromechanischen oder mikro-opto-elektromechanischen Bauteils, bereitzustellen, mit dem eine aktive Struktur des Bauteils mit zwei getrennten Teilen oder Bereichen, die zwar mechanisch starr miteinander verbunden, aber vollständig elektrisch isoliert voneinander sind, realisiert werden kann.

Die Aufgabe wird gelöst durch den Gegenstand des unabhängigen Patentanspruchs. Bevorzugte Ausführungsformen finden sich in den Unteransprüchen.

Ein Verfahren zum Herstellen eines Bauteils gemäß der vorliegenden Erfindung umfasst das Erzeugen eines ersten Schichtverbundes, der eine Strukturschicht, die mindestens in einem ersten Bereich elektrisch leitfähig ist, und einen mit einem isolierenden Material gefüllten Graben, der sich von einer ersten Oberfläche der Strukturschicht aus erstreckt und in dem ersten Bereich der Strukturschicht angeordnet ist, umfasst. Dabei ist die erste Oberfläche der Strukturschicht einer ersten Oberfläche des ersten Schichtverbundes zugewandt. Weiterhin umfasst das Verfahren zum Herstellen eines Bauteils das Erzeugen eines zweiten Schichtverbundes, der eine erste Vertiefung in einer ersten Oberfläche des zweiten Schichtverbundes aufweist, und das Verbinden des ersten Schichtverbundes mit dem zweiten Schichtverbund, wobei die erste Oberfläche des ersten Schichtverbundes zumindest in Bereichen an die erste Oberfläche des zweiten Schichtverbundes angrenzt und wobei der gefüllte Graben innerhalb der lateralen Position der ersten Vertiefung angeordnet wird. Nach dem Verbinden des ersten Schichtverbundes mit dem zweiten Schichtverbund wird die Dicke des ersten Schichtverbundes von einer zweiten Oberfläche des ersten Schichtverbundes aus bis zur Tiefe des gefüllten Grabens reduziert, wobei die zweite Oberfläche des ersten Schichtverbundes der ersten Oberfläche des ersten Schichtverbundes gegenüberliegt. Weiterhin umfasst das Verfahren das Erzeugen einer aktiven Struktur des Bauteils in der Strukturschicht, wobei die aktive Struktur innerhalb der lateralen Position der ersten Vertiefung angeordnet ist und zwei zweite Bereiche der Strukturschicht umfasst. Die zweiten Bereiche der Strukturschicht sind im ersten Bereich der Strukturschicht angeordnet, physisch starr miteinander verbunden und durch den gefüllten Graben elektrisch voneinander isoliert

Gemäß einer Ausführungsform des Verfahrens zum Herstellen eines Bauteils kann sich der gefüllte Graben im ersten Schichtverbund vor dem Verbinden des ersten Schichtverbundes mit dem zweiten Schichtverbund bis zu einer Tiefe erstrecken, die kleiner als die Dicke des ersten Schichtverbundes ist. Das heißt, der gefüllte Graben reicht nicht bis zu einer zweiten Oberfläche des ersten Schichtverbundes, die der ersten Oberfläche des ersten Schichtverbundes gegenüber liegt.

Gemäß einer spezifischen Ausführungsform umfasst der erste Schichtverbund weiterhin eine Hilfsschicht, die an eine zweite Oberfläche der Strukturschicht angrenzt, wobei die zweite Oberfläche der Strukturschicht der ersten Oberfläche der Strukturschicht gegenüberliegt. Der gefüllte Graben erstreckt sich dabei bis zur zweiten Oberfläche der Strukturschicht.

Gemäß einer Ausführungsform des Verfahrens sind im ersten Schichtverbund vor dem Verbinden des ersten Schichtverbundes mit dem zweiten Schichtverbund neben dem mit isolierendem Material gefüllten Graben keine weiteren Strukturen ausgebildet. Insbesondere sind keine Trenngräben, das heißt nicht mit einem Material gefüllte Gräben, ausgebildet.

In diesem Fall wird die Strukturschicht nach dem Reduzieren der Dicke des ersten Schichtverbundes bis zur Tiefe des gefüllten Grabens strukturiert, um die aktive Struktur des Bauteils zu erzeugen.

Gemäß einer anderen Ausführungsform des Verfahrens werden im ersten Schichtverbund vor dem Verbinden des ersten Schichtverbundes mit dem zweiten Schichtverbund neben dem gefüllten Graben Trenngräben ausgebildet, die nicht mit einem Material gefüllt sind und sich von der ersten Oberfläche des ersten Schichtverbundes bis zu einer Tiefe erstrecken, die gleich oder größer als eine Tiefe des gefüllten Grabens ist. Die Trenngräben definieren dabei die laterale Begrenzung der in einem späteren Verfahrensschritt erzeugten aktiven Struktur.

In diesem Fall kann die aktive Struktur des Bauteils durch das Reduzieren der Dicke des ersten Schichtverbundes bis zur Tiefe des gefüllten Grabens erzeugt werden.

Gemäß einer Ausführungsform umfasst das Verfahren zum Herstellen eines Bauteils weiterhin das Erzeugen eines dritten Schichtverbundes, der eine erste Oberfläche aufweist, und das Verbinden des ersten Schichtverbundes mit dem dritten Schichtverbund nach dem Erzeugen der aktiven Struktur, wobei die erste Oberfläche des dritten Schichtverbundes zumindest in Bereichen an die zweite Oberfläche des ersten Schichtverbundes angrenzt. Damit kann die Strukturschicht hermetisch dicht verkapselt werden.

Vor dem Verbinden des ersten Schichtverbundes mit dem dritten Schichtverbund kann in der der ersten Oberfläche des dritten Schichtverbundes eine zweite Vertiefung erzeugt werden. Beim Verbinden des ersten Schichtverbundes mit dem dritten Schichtverbund wird die aktive Struktur innerhalb der lateralen Position der zweiten Vertiefung angeordnet.

Gemäß einer Ausführungsform bestehen die dem dritten Schichtverbund zugewandte Schicht des ersten Schichtverbundes und die dem ersten Schichtverbund zugewandte Schicht des dritten Schichtverbundes aus dem selben Material.

Gemäß einer weiteren Ausführungsform bestehen die dem zweiten Schichtverbund zugewandte Schicht des ersten Schichtverbundes und die dem ersten Schichtverbund zugewandte Schicht des zweiten Schichtverbundes aus dem selben Material.

Für den Fall, dass die miteinander zu verbindenden Schichten, das heißt die dem zweiten Schichtverbund zugewandte Schicht des ersten Schichtverbundes und die dem ersten Schichtverbund zugewandte Schicht des zweiten Schichtverbundes und gegebenenfalls die dem dritten Schichtverbund zugewandte Schicht des ersten Schichtverbundes und die dem ersten Schichtverbund zugewandte Schicht des dritten Schichtverbundes, aus demselben Material bestehen, können besonders geeignete Verfahren zum Verbinden dieser Schichten, zum Beispiel Bondprozesse, genutzt werden. Beispielsweise können die entsprechenden Schichten aus einem Halbleitermaterial, insbesondere Silizium, bestehen.

Ausführungsformen des erfindungsgemäßen Verfahrens werden im Folgenden anhand der Figuren näher erläutert, wobei gleichartige Elemente mit gleichen Bezugszeichen gekennzeichnet sind.

Die Figur 1 zeigt einen ersten Schichtverbund gemäß einer Ausführungsform des Verfahrens in einem Querschnitt.

Die Figur 2 zeigt einen ersten Schichtverbund gemäß einer anderen Ausführungsform des Verfahrens in einem Querschnitt.

Die Figur 3 zeigt einen zweiten Schichtverbund gemäß einer Ausführungsform des Verfahrens in einem Querschnitt.

Die Figur 4 zeigt ein Bauteil gemäß einer Ausführungsform des Verfahrens nach dem Verbinden des ersten und des zweien Schichtverbundes in einem Querschnitt.

Die Figur 5 zeigt das Bauteil aus Figur 4 nach dem Reduzieren der Dicke des ersten Schichtverbundes in einem Querschnitt.

Die Figur 6 zeigt das Bauteil aus Figur 5 nach dem Strukturieren der Strukturschicht gemäß einer Ausführungsform des Verfahrens in einem Querschnitt.

Die Figur 7 zeigt einen dritten Schichtverbund gemäß einer Ausführungsform des Verfahrens in einem Querschnitt.

Die Figur 8 zeigt das Bauteil aus Figur 6 nach dem Verbinden des Bauteils mit dem dritten Schichtverbund aus Figur 7 in einem Querschnitt.

Die Figur 9 zeigt das Bauteil aus Figur 8 nach weiteren Prozessschritten gemäß einer Ausführungsform des Verfahrens in einem Querschnitt.

Die Figur 10 zeigt einen ersten Schichtverbund gemäß einer weiteren Ausführungsform des Verfahrens in einem Querschnitt.

Die Figur 11 zeigt ein Bauteil gemäß einer Ausführungsform des Verfahrens nach dem Verbinden des ersten Schichtverbundes aus Figur 10 und des zweien Schichtverbundes in einem Querschnitt.

Die Figur 12 zeigt das Bauteil aus Figur 11 nach dem Reduzieren der Dicke des ersten Schichtverbundes in einem Querschnitt.

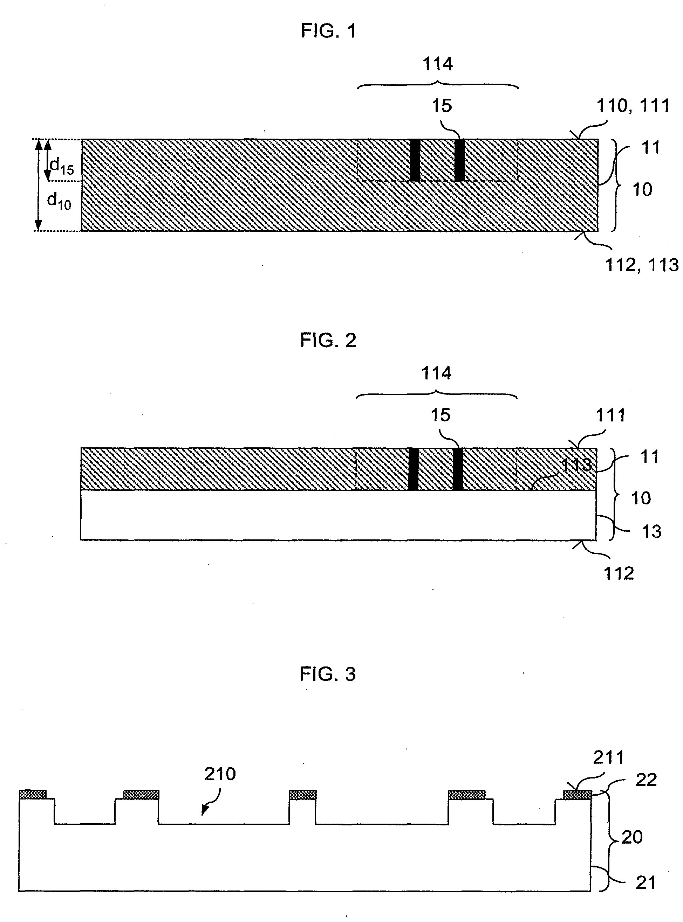

Die Figur 1 zeigt einen Querschnitt durch einen erzeugten ersten Schichtverbund 10 gemäß einer ersten Ausführungsform. Der in der Figur 1 dargestellte erste Schichtverbund 10 umfasst eine Strukturschicht 11 und einen mit einem isolierenden Material gefüllten Graben 15. In Figur 1 sind zwei gefüllte Gräben 15 dargestellt, jedoch ist für das erfindungsgemäße Verfahren bereits ein gefüllter Graben ausreichend. Der erste Schichtverbund 10 weist eine erste Oberfläche 110 und eine zweite Oberfläche 112 auf, die der ersten Oberfläche 110 des ersten Schichtverbundes 10 gegenüberliegt. Die Strukturschicht 11 weist eine erste Oberfläche 111 und eine zweite Oberfläche 113 auf, die der ersten Oberfläche 111 gegenüberliegt. In der in Figur 1 dargestellten Ausführungsform umfasst der erste Schichtverbund nur die Strukturschicht 11, so dass die erste Oberfläche 111 der Strukturschicht 11 der ersten Oberfläche 110 des ersten Schichtverbundes 10 entspricht und die zweite Oberfläche 113 der Strukturschicht 11 der zweiten Oberfläche 112 des ersten Schichtverbundes 10 entspricht.

Die Strukturschicht 11 weist mindestens einen ersten Bereich 114 auf, der elektrisch leitfähig ist und in dem der gefüllte Graben 15 ausgebildet ist. Dabei können mehrere gefüllte Gräben 15 in ein und demselben ersten Bereich 114 ausgebildet sein, wie dies in Figur 1 dargestellt ist. Jedoch können verschiedene gefüllte Gräben 15 auch in verschiedenen ersten Bereichen 114, die voneinander elektrisch isoliert sind, ausgebildet sein. Der oder die ersten Bereiche 114 können sich von der ersten Oberfläche 111 der Strukturschicht 11 aus erstrecken und können bis zu einer Tiefe d₁₅ der gefüllten Gräben 15 reichen, wie dies in Figur 1 dargestellt ist. Jedoch können der oder die ersten Bereiche 114 sich auch bis zu einer anderen Tiefe, die von der Tiefe d₁₅ der gefüllten Gräben 15 verschieden ist, reichen oder können als vergrabene Bereiche ausgebildet sein, die an keine der ersten oder zweiten Oberfläche 111 bzw. 113 der Strukturschicht 11 angrenzen. Der oder die ersten Bereiche 114 können beispielsweise dotierte Gebiete in einer Halbleiterschicht oder einem Halbleitersubstrat, zum Beispiel aus Silizium, sein. Ebenfalls möglich ist, dass die gesamte Strukturschicht 11 elektrisch leitfähig ist und sich der erste Bereich 114 damit über die gesamte Strukturschicht 11 erstreckt.

Der Begriff "Strukturschicht" beschreibt hierbei Gebilde, die nur aus einem Material bestehen, beispielsweise einen Siliziumwafer, die aber auch einen Verbund aus mehreren Schichten und Materialien beinhalten können, solange der erste Bereich 114 der Strukturschicht 11 elektrisch leitfähig ist.

In einem späteren Prozessschritt wird in dem ersten Bereich 114 eine aktive Struktur eines Bauteils erzeugt, wobei der gefüllte Graben einzelne Bereiche der aktiven Struktur elektrisch voneinander isoliert. Es können auch mehrere aktive Strukturen erzeugt werden. Damit ergibt sich die Anzahl der gefüllten Gräben aus der Anzahl der später zu erzeugenden Bereiche einer oder mehrerer aktiven Strukturen in der Strukturschicht, wobei die Bereiche physisch starr miteinander verbunden, jedoch elektrisch voneinander isoliert sein sollen. Das heißt, die Anzahl der gefüllten Gräben 15, der ersten Bereiche 114, der voneinander isolierten Bereiche einer aktiven Struktur und der aktiven Strukturen ist nicht beschränkt.

Der oder die gefüllten Gräben 15 sind mit isolierendem Material gefüllt und erstrecken sich von der ersten Oberfläche 111 des ersten Substrates 11 bis zur Tiefe d₁₅. Gemäß einer Ausführungsform ist die Tiefe d₁₅ der gefüllten Gräben 15 kleiner als eine Dicke d₁₀ des ersten Schichtverbundes 10. Damit reichen die gefüllten Gräben 15 nicht bis zur zweiten Oberfläche 112 des ersten Schichtverbundes 10. In der Draufsicht können die gefüllten Gräben 15 beliebig angeordnet sein und beliebige Formen aufweisen. Sie können beispielsweise in der Draufsicht geradlinig oder gekrümmt verlaufen und, falls mehrere gefüllte Gräben 15 ausgebildet sind, parallel oder in einem Winkel zueinander ausgebildet sein. Die gefüllten Gräben 15 können sich im Querschnitt beliebig von der ersten Oberfläche 111 aus erstrecken. Das heißt, die gefüllten Gräben 15 können senkrecht zur ersten Oberfläche 111 oder in einem definierten Winkel zu dieser Oberfläche, geradlinig oder gekrümmt verlaufen. Die Breite der gefüllten Gräben 15 kann über ihre Tiefe variieren. Darüber hinaus können verschiedene gefüllte Gräben 15 unterschiedlich ausgebildet sein, wobei die Tiefe aller gefüllten Gräben 15 vorzugsweise gleich ist.

Die gefüllten Gräben 15 können mithilfe eines Ätzverfahrens, beispielsweise eines Trockenätzverfahrens (DRIE) oder eines stark anisotropen Nassätzverfahrens, unter zu Hilfenahme einer Maske oder mit Hilfe von anderen Verfahren sowie einem anschließenden Füllprozess der entstandenen Gräben mit einem isolierendem Material erzeugt werden. Die Gräben werden von der ersten Oberfläche 111 der Strukturschicht 11 aus erzeugt. Das isolierende Material, mit dem die Gräben aufgefüllt werden, kann beispielsweise mit Hilfe eines chemischen oder physikalischen Abscheideverfahrens (CVD bzw. PVD) in die Gräben gefüllt werden. Im Anschluss an das Auffüllen der Gräben mit dem isolierenden Material wird überschüssiges isolierendes Material, das sich auf der ersten Oberfläche 111 befindet, wieder entfernt. Dies kann mit Hilfe eines chemisch-mechanischen Polierverfahrens (CMP) oder mit Hilfe eines Ätzprozesses durchgeführt werden.

In Figur 1 ist das Ergebnis dieses Prozessschrittes dargestellt.

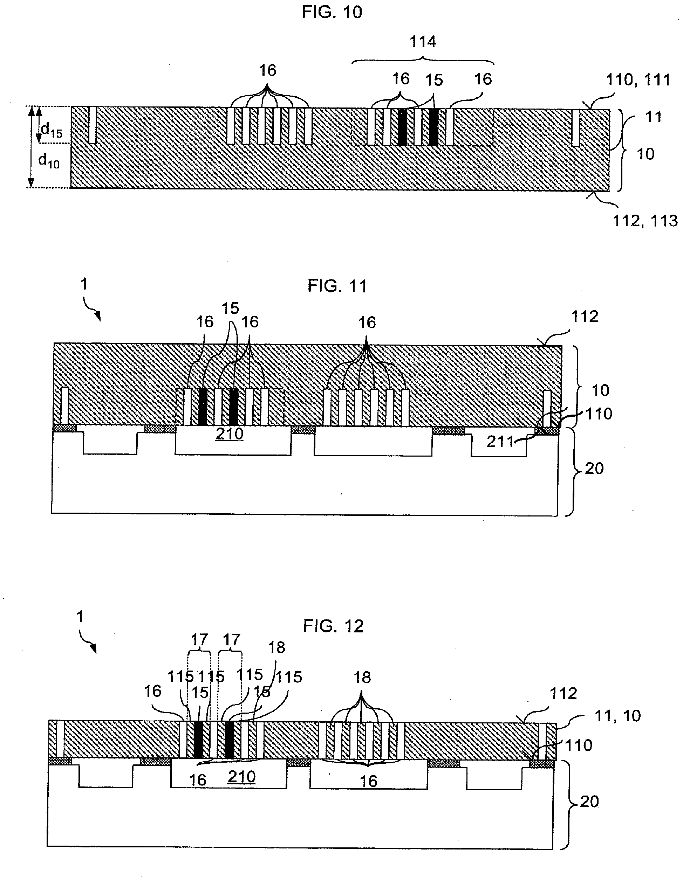

Optional können weitere Strukturen im ersten Schichtverbund 10 erzeugt sein. Beispielsweise können weitere Gräben, die sich von der ersten Oberfläche 110 des ersten Schichtverbundes 10 oder von der ersten Oberfläche 111 der Strukturschicht 11 erstrecken, jedoch nicht mit einem Material gefüllt sind, oder weitere elektrisch leitfähige Bereiche in der Strukturschicht 11, in denen jedoch keine mit isolierendem Material gefüllte Gräben 15 angeordnet sind, ausgebildet sein. Dies wird später mit Bezug auf die Figuren 10 bis 12 näher erläutert.

Figur 2 zeigt eine andere Ausführungsform des ersten Schichtverbundes 10 im Ergebnis des ersten Prozessschrittes des erfindungsgemäßen Verfahrens. Hierbei umfasst der Schichtverbund 10 neben der Strukturschicht 11 und dem gefüllten Graben 15 eine Hilfsschicht 13, die an die zweite Oberfläche 113 der Strukturschicht 11 angrenzt. Gemäß der in Figur 2 dargestellten Ausführungsform entspricht die erste Oberfläche 111 der Strukturschicht 11 der ersten Oberfläche 110 des ersten Schichtverbundes 10, während die zweite Oberfläche 113 der Strukturschicht 11 der zweiten Oberfläche 112 des ersten Schichtverbundes 10 zugewandt ist, dieser jedoch nicht entspricht.

Die Hilfsschicht 13 kann aus einem isolierendem Material, beispielsweise Siliziumoxid, oder aus einem beliebigen anderen Material bestehen, solange sie gut auf der Strukturschicht 11 haftet und in einem späteren Prozessschritt wieder entfernbar ist. Darüber hinaus kann die Hilfsschicht 13 auch aus mehreren Schichten bestehen. Der oder die gefüllten Gräben 15 können sich bis zu einer beliebigen Tiefe in den ersten Schichtverbund 10 erstrecken. Vorzugsweise erstrecken sie sich bis zur zweiten Oberfläche 113 der Strukturschicht 11, wie in Figur 2 dargestellt. Jedoch können sie sich auch bis zu einer Tiefe erstrecken, die kleiner oder größer als eine Dicke der Strukturschicht 11 ist.

Bezüglich des ersten Bereiches 114 der Strukturschicht 11 sowie der Lage und Form der gefüllten Gräben 15 und deren Erzeugen gilt das oben Ausgeführte.

Optional kann der in den Figuren 1 oder 2 dargestellte erste Schichtverbund 10 auch eine oder mehrere weitere Schichten umfassen, die beliebig angeordnet sein können. Beispielsweise kann eine zusätzliche Schicht auf der ersten Oberfläche 111 der Strukturschicht 11 angeordnet sein und an die erste Oberfläche 110 des ersten Schichtverbundes 10 angrenzen. Damit entspricht die erste Oberfläche 111 der Strukturschicht 11 nicht der ersten Oberfläche 110 des ersten Schichtverbundes 10, sondern ist dieser zugewandt, aber von ihr durch die zusätzliche Schicht beabstandet. Die zusätzliche Schicht kann aus einem isolierenden Material bestehen und nach dem Erzeugen der gefüllten Gräben 15 aufgebracht sein, so dass sich die gefüllten Gräben 15 von der ersten Oberfläche 111 der Strukturschicht 11 aus erstrecken. Die zusätzliche Schicht kann aber auch vor dem Erzeugen der gefüllten Gräben 15 aufgebracht worden sein, so dass sich die gefüllten Gräben 15 von der ersten Oberfläche 110 des ersten Schichtverbundes 10 aus erstrecken.

In einem zweiten Prozessschritt, dessen Ergebnis in Figur 3 dargestellt ist, wird ein zweiter Schichtverbund 20 erzeugt. Der zweite Schichtverbund 20 kann, wie in Figur 3 dargestellt, ein erstes Substrat 21, beispielsweise aus einem elektrisch leitfähigen Material, und eine erste Schicht 22, beispielsweise aus einem isolierenden Material, umfassen. Möglich sind auch andere Materialkombinationen, beispielsweise kann das erste Substrat 21 aus einem elektrisch isolierenden Material und die erste Schicht 22 aus einem elektrisch leitfähigen Material bestehen. Hierbei beschreibt der Begriff "Substrat" Gebilde, die nur aus einem Material bestehen, beispielsweise einen Siliziumwafer oder eine Glasscheibe, die aber auch einen Verbund aus mehreren Schichten und Materialien beinhalten können. Jedoch kann der zweite Schichtverbund 20 auch nur aus einem ersten Substrat 21 bestehen.

Der zweite Schichtverbund 20 weist eine erste Vertiefung 210 auf, die in einer ersten Oberfläche 211 des zweiten Schichtverbundes 20 ausgebildet ist. Die erste Vertiefung 210 weist eine Tiefe auf, die kleiner als eine Dicke des zweiten Schichtverbundes 20 ist. Der zweite Schichtverbund 20 kann auch mehrere erste Vertiefungen 210 sowie weitere Vertiefungen aufweisen, wobei die weiteren Vertiefungen die selbe Tiefe wie die erste Vertiefung 210 oder eine davon verschiedene Tiefe aufweisen können.

Der Schritt zum Erzeugen des zweiten Schichtverbundes 20 ist zeitlich unabhängig vom Schritt zum Erzeugen des ersten Schichtverbundes 10 und kann vor oder nach diesem erfolgen.

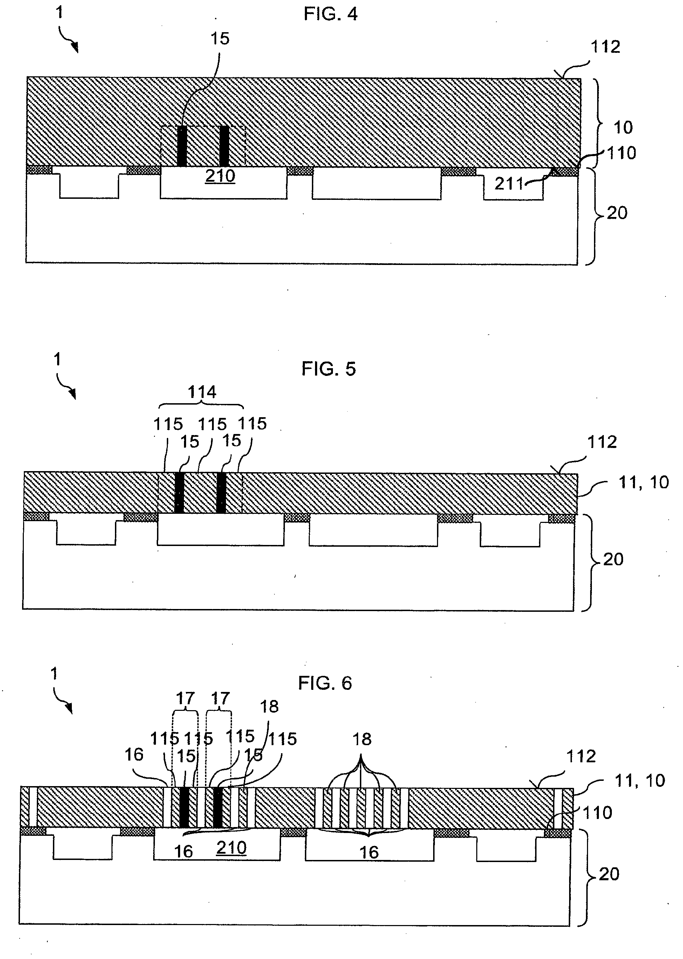

In einem weiteren Prozessschritt, dessen Ergebnis in Figur 4 dargestellt ist, wird der erste Schichtverbund 10 mit dem zweiten Schichtverbund 20 verbunden und ein Bauteil 1 erzeugt. Für die Darstellung in Figur 4 wurde der in Figur 1 dargestellte erste Schichtverbund 10 und der in Figur 3 dargestellte zweite Schichtverbund 20 gewählt. Jedoch können der erste Schichtverbund 10 und der zweite Schichtverbund 20 beliebig wie oben beschrieben ausgebildet sein. Im Ergebnis grenzt die erste Oberfläche 110 des ersten Schichtverbundes 10 zumindest in Bereichen an die erste Oberfläche 211 des zweiten Schichtverbundes 20 an, wobei der oder die gefüllten Gräben 15 innerhalb der lateralen Position der ersten Vertiefung 210 im zweiten Schichtverbund 20 angeordnet werden. Damit wird sichergestellt, dass eine aktive Struktur, die in einem späteren Prozessschritt in der Strukturschicht 11 erzeugt wird und mindestens einen gefüllten Graben 15 umfasst, sich bezüglich des zweiten Schichtverbundes 20 frei bewegen kann und nicht an die erste Oberfläche 211 des zweiten Schichtverbundes 20 anstößt.

Zum Verbinden des ersten und des zweiten Schichtverbundes 10 und 20 können beispielsweise Fügeverfahren auf Basis von Direktbondprozessen sowie anodischen Bondprozessen eingesetzt werden. Damit können insbesondere MEMS- bzw. MOEMS-Bauteile kostengünstig produziert werden. Des Weiteren ermöglicht ein solches Fügeverfahren eine stabile und hermetisch dichte Verbindung des ersten und des zweiten Schichtverbundes 10 und 20 miteinander.

Da sich die gefüllten Gräben 15 vorzugsweise nicht bis zur zweiten Oberfläche 112 des ersten Schichtverbundes 10 erstrecken, können besonders geeignete Parameter während des Prozesses zum Verbinden des ersten und des zweiten Schichtverbundes 10 und 20 eingesetzt werden, beispielsweise hohe Anpressdrücke und/oder Luftunterdrücke während eines Bondprozesses.

Da in der derzeit beschriebenen Ausführungsform des Verfahrens bis zu diesem Prozessschritt außer den mit isolierendem Material gefüllten Gräben 15 keine weiteren Strukturen, insbesondere keine nicht mit einem Material gefüllte Gräben, im ersten Schichtverbund 10 ausgebildet sind, weist der erste Schichtverbund 10 eine erhöhte Stabilität beim Verbindungsprozess auf, was die Verwendung besonders geeigneter Prozessparameter ermöglicht.

Besonders vorteilhaft für einen Bondprozess ist es, wenn die miteinander zu verbindenden Schichten des ersten Schichtverbundes 10 und des zweiten Schichtverbundes 20 aus dem selben Material bestehen. Das heißt, die dem zweiten Schichtverbund 20 zugewandte Schicht des ersten Schichtverbundes 10 und die dem ersten Schichtverbund 10 zugewandte Schicht des zweiten Schichtverbundes 20 können aus dem selben Material bestehen, zum Beispiel aus Silizium.

In einem nächsten Prozessschritt, dessen Ergebnis in Figur 5 dargestellt ist, wird der erste Schichtverbund 10 von der zweiten Oberfläche 112 aus bis zur Tiefe d₁₅ der gefüllten Gräben 15 abgedünnt, das heißt die Dicke des ersten Schichtverbundes 10 wird auf eine Dicke, die der Tiefe d₁₅ der gefüllten Gräben 15 entspricht, reduziert. Dies kann beispielsweise mithilfe eines CMP-Prozesses oder eines Ätzprozesses durchgeführt werden. Dabei wird das Material des ersten Schichtverbundes 10 soweit entfernt, bis die gefüllten Gräben 15 erreicht werden. Im Ergebnis grenzen die gefüllten Gräben 15 an die zweite Oberfläche 112 des ersten Schichtverbundes 10 an und isolieren damit spezifische zweite Bereiche 115 der Strukturschicht 11 zumindest bereichsweise elektrisch von anderen Bereichen der Strukturschicht 11 innerhalb des ersten Bereiches 114 der Strukturschicht 11. "Zumindest bereichsweise" bedeutet hier, dass die zweiten Bereiche 115 möglicherweise in einer anderen Querschnittsebene, in der die gefüllten Gräben 15 nicht ausgebildet sind, noch elektrisch leitend miteinander verbunden sein können. Dies kann insbesondere dann der Fall sein, wenn noch keine weiteren Strukturen außer den gefüllten Gräben 15 im ersten Schichtverbund 10 erzeugt sind.

In Figur 6 ist das Ergebnis eines Prozessschrittes zum Erzeugen weiterer Strukturen im ersten Schichtverbund 10 dargestellt. Insbesondere werden Trenngräben 16 im ersten Schichtverbund 10, der beispielsweise nur die Strukturschicht 11 umfassen kann, durch einen Ätzprozess ausgebildet, wobei die Trenngräben 16 nicht mit einem Material gefüllt werden und damit einzelne Bereiche oder Strukturen im ersten Schichtverbund 10 physisch voneinander trennen. Dadurch können beispielsweise eine oder mehrere aktive Strukturen 17 und andere Strukturen 18, die ebenfalls beweglich sein können, erzeugt werden. In Figur 6 sind zwei aktive Strukturen 17 und sechs andere Strukturen 18 dargestellt, jedoch ist die Anzahl der aktiven Strukturen 17 und der anderen Strukturen 18 nicht beschränkt und die anderen Strukturen 18 können beispielsweise auch gar nicht ausgebildet sein.

Die beiden dargestellten aktiven Strukturen 17 umfassen jeweils zwei zweite Bereiche 115 der Strukturschicht 11, wobei die zweiten Bereiche 115 zumindest teilweise im ersten Bereich 114 der Strukturschicht 11 angeordnet sind. Vorzugsweise sind die zweiten Bereiche 115 vollständig elektrisch leitfähig, das heißt sie sind vollständig im ersten Bereich 114 der Strukturschicht 11 angeordnet. Die Trenngräben 16 sind so angeordnet, dass sie die aktiven Strukturen 17 lateral begrenzen und - in Verbindung mit dem gefüllten Graben 15 - die zweiten Bereiche 115 einer der aktiven Strukturen 17 elektrisch voneinander isolieren, wobei jedoch die zweiten Bereiche 115 der spezifischen aktiven Struktur 17 physisch starr miteinander verbunden sind. Damit können an verschiedene zweite Bereiche 115 der aktiven Struktur 17 unterschiedliche Potentiale angelegt werden, beispielsweise über elektrisch leitfähige Federn, die die zweiten Bereiche 115 der aktiven Struktur 17 mit entsprechenden Elektroden verbinden und eine Bewegung der aktiven Struktur 17 erlauben. Um eine Bewegung der aktiven Struktur auch in einer Richtung senkrecht zur ersten Oberfläche 110 des ersten Schichtverbundes 10 zu ermöglichen, ist die aktive Struktur 17 innerhalb der lateralen Position der ersten Vertiefung 210 im zweiten Schichtverbund 20 angeordnet.

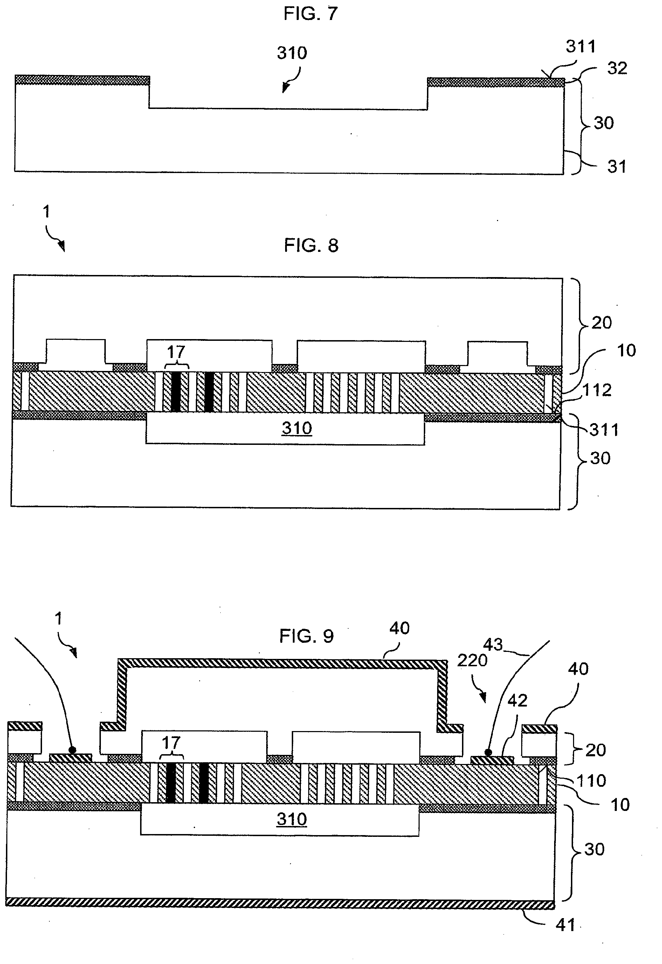

In einem weiteren Prozessschritt des Verfahrens zum Herstellen eines Bauteils kann gemäß einer Ausführungsform ein dritter Schichtverbund 30 erzeugt werden. Das Ergebnis dieses Schrittes ist in Figur 7 dargestellt. Der dritte Schichtverbund 30 kann, wie in Figur 7 dargestellt, ein zweites Substrat 31, beispielsweise aus einem elektrisch leitfähigen Material, und eine zweite Schicht 32, beispielsweise aus einem isolierenden Material, umfassen. Möglich sind auch andere Materialkombinationen, beispielsweise kann das zweite Substrat 31 aus einem elektrisch isolierenden Material und die zweite Schicht 32 aus einem elektrisch leitfähigen Material bestehen. Hierbei beschreibt der Begriff "Substrat" Gebilde, die nur aus einem Material bestehen, beispielsweise einen Siliziumwafer oder eine Glasscheibe, die aber auch einen Verbund aus mehreren Schichten und Materialien beinhalten können. Jedoch kann der dritte Schichtverbund 30 auch nur aus einem zweiten Substrat 31 bestehen.

Der dritte Schichtverbund 30 weist vorzugsweise mindestens eine zweite Vertiefung 310 auf, die in einer ersten Oberfläche 311 des dritten Schichtverbundes 30 ausgebildet ist. Die zweite Vertiefung 310 weist eine Tiefe auf, die kleiner als eine Dicke des dritten Schichtverbundes 30 ist. Der dritte Schichtverbund 30 kann auch mehrere zweite Vertiefungen 310 sowie weitere Vertiefungen aufweisen, wobei die weiteren Vertiefungen die selbe Tiefe wie die zweite Vertiefung 310 oder eine davon verschiedene Tiefe aufweisen können.

Der Schritt zum Erzeugen des dritten Schichtverbundes 30 ist zeitlich unabhängig von den bisher beschriebenen Prozessschritten und kann vor oder nach einzelnen oder allen der bisher beschriebenen Prozessschritte erfolgen.

In einem weiteren Prozessschritt, dessen Ergebnis in Figur 8 dargestellt ist, wird das bereits vorliegende Bauteil 1, das den ersten Schichtverbund 10 und den zweiten Schichtverbund 20 umfasst und in dem die aktive Struktur 17 ausgebildet ist, mit dem dritten Schichtverbund 30 verbunden. Für die Darstellung in Figur 8 wurde die in Figur 6 dargestellte Ausführungsform des Bauteils 1 gewählt. Jedoch können der erste Schichtverbund 10 und der zweite Schichtverbund 20 beliebig wie oben beschrieben ausgebildet sein. Im Ergebnis grenzt die zweite Oberfläche 112 des ersten Schichtverbundes 10 zumindest in Bereichen an die erste Oberfläche 311 des dritten Schichtverbundes 30 an, wobei die aktive Struktur 17 innerhalb der lateralen Position der zweiten Vertiefung 310 im dritten Schichtverbund 30 angeordnet wird. Damit wird sichergestellt, dass die aktive Struktur 17 sich bezüglich des dritten Schichtverbundes 30 frei bewegen kann und nicht an die erste Oberfläche 311 des dritten Schichtverbundes 30 anstößt.

Zum Verbinden des ersten und des dritten Schichtverbundes 10 und 30 können beispielsweise Fügeverfahren auf Basis von Direktbondprozessen sowie anodischen Bondprozessen eingesetzt werden. Dies ermöglicht eine hermetisch dichte Verbindung des ersten und des dritten Schichtverbundes 10 und 30 miteinander. Im Ergebnis ist die aktive Struktur 17 hermetisch dicht abgekapselt.

Besonders vorteilhaft für einen Bondprozess ist es, wenn die miteinander zu verbindenden Schichten des ersten Schichtverbundes 10 und des dritten Schichtverbundes 30 aus dem selben Material bestehen. Das heißt, die dem driiten Schichtverbund 30 zugewandte Schicht des ersten Schichtverbundes 10 und die dem ersten Schichtverbund 10 zugewandte Schicht des dritten Schichtverbundes 30 können aus dem selben Material, beispielsweise Silizium, bestehen.

Nachfolgend können weitere Prozessschritte zum Fertigstellen des Bauteils 1 ausgeführt werden, deren Ergebnis in einer Ausführungsform in Figur 9 dargestellt ist. So kann beispielsweise eine erste Deckschicht 40 auf dem zweiten Schichtverbund 20 und eine zweite Deckschicht 41 auf dem dritten Schichtverbund 30 aufgebracht werden. Die erste und die zweite Deckschicht 40 und 41 können aus dem selben Material, beispielsweise einem Metall, oder aus unterschiedlichen Materialien bestehen. Sie können der Abschirmung eines aktiven Gebietes des Bauteils 1 vor äußeren elektrischen Feldern oder anderen Umwelteinflüssen, wie beispielsweise Feuchtigkeit, dienen. Darüber hinaus können Kontaktflächen 42 zur elektrischen Kontaktierung des ersten Schichtverbundes 10, insbesondere der Strukturschicht 11, sowie elektrische Kontakte 43 erzeugt werden. Beispielsweise kann eine Metallschicht auf der ersten Oberfläche 110 des ersten Schichtverbundes 10 als Kontaktfläche 42 in einer dritten Vertiefung 220 im zweiten Schichtverbund 20 erzeugt und mittels eines Drahtes 43 elektrisch kontaktiert werden. Jedoch sind auch andere Verfahren zur Herstellung eines elektrischen Kontaktes zum ersten Schichtverbund 10 möglich.

Wie bereits erwähnt, können im ersten Schichtverbund 10 vor dem Verbinden mit dem zweiten Schichtverbund 20 neben dem oder den gefüllten Gräben 15 auch weitere Strukturen erzeugt werden. Eine beispielhafte Ausführungsform ist in Figur 10 dargestellt. Hier weist der erste Schichtverbund 10 mehrere Trenngräben 16 auf, die nicht mit einem Material gefüllt sind. Die Trenngräben 16 erstrecken sich von der ersten Oberfläche 110 des ersten Schichtverbundes 10 aus bis zu einer Tiefe, die vorzugsweise gleich oder größer als die Tiefe d₁₅ der gefüllten Gräben 15, aber kleiner als die Dicke d₁₀ des ersten Schichtverbundes ist. Dabei sind die Trenngräben 16 so angeordnet, dass sie einen oder mehrere Bereiche der Strukturschicht 11 begrenzen, wobei jeder Bereich einer aktiven Struktur des Bauteils entspricht.

Ähnlich wie in Figur 2, kann der erste Schichtverbund 10 auch eine Hilfsschicht 13 aufweisen, wobei sich die Trenngräben 16 vorzugsweise bis zur zweiten Oberfläche 113 der Strukturschicht 11 erstrecken.

Darüber hinaus können sich die Trenngräben 16 auch von der ersten Oberfläche 111 der Strukturschicht 11 aus erstrecken. Das heißt, wenn sich auf der Oberfläche 111 der Strukturschicht 11 noch eine zusätzliche Schicht befindet, so müssen die Trenngräben 16 sich nicht notwendigerweise von der ersten Oberfläche 110 des ersten Schichtverbundes 10 aus erstrecken.

Die Figur 11 zeigt ein Bauteil 1 nach dem Verbinden des in Figur 10 dargestellten ersten Schichtverbundes 10 mit dem in Figur 3 dargestellten zweiten Schichtverbund 20. Da die Trenngräben 16 sich vorzugsweise nicht bis zur zweiten Oberfläche 112 des ersten Schichtverbundes 10 erstrecken und damit die Stabilität des ersten Schichtverbundes 10 nicht wesentlich beeinträchtigen, können zum Verbinden des ersten Schichtverbundes 10 mit dem zweiten Schichtverbund 20 ebenfalls besonders geeignete Verfahren und Prozessparameter, wie mit Bezug auf Figur 4 beschrieben, eingesetzt werden.

Im Anschluss an den Schritt zum Verbinden des ersten Schichtverbundes 10 mit dem zweiten Schichtverbund 20 wird der erste Schichtverbund 10 von der zweiten Oberfläche 112 des ersten Schichtverbundes 10 aus abgedünnt. Dazu bieten sich vorzugsweise Chemisch-Mechanische Polierverfahren (CMP) und Ätzverfahren an. Dabei wird die Dicke des ersten Schichtverbundes 10 auf eine Dicke, die der Tiefe d₁₅ der gefüllten Gräben 15 entspricht, reduziert, so dass die gefüllten Gräben 15 an die zweite Oberfläche 112 des ersten Schichtverbundes 10 angrenzen. Während des Abdünnens des ersten Schichtverbundes 10 werden gleichzeitig die Trenngräben 16 an der zweiten Oberfläche 112 des ersten Schichtverbundes 10 geöffnet, wodurch die aktiven Strukturen 17 und die anderen Strukturen 18 erzeugt werden können. Das Ergebnis dieses Prozessschrittes ist in Fig. 12 dargestellt,

Wenn sich die Trenngräben 16, wie oben beschrieben, nicht von der ersten Oberfläche 110 des ersten Schichtverbundes 10 aus erstrecken, müssen die Trenngräben 16 anschließend noch bis zur ersten Oberfläche 110 des ersten Schichtverbundes 10 geöffnet werden, damit eine bewegliche aktive Struktur 17 erzeugt wird. Dies kann durch einen Ätzprozess erfolgen, bei dem die oben beschriebene zusätzliche Schicht, die die Trenngräben 16 an der ersten Oberfläche 110 des ersten Schichtverbundes 10 bedeckt, zumindest in den Bereichen der Trenngräben 16 entfernt wird.

Die weitere Prozessierung des in Figur 12 dargestellten Bauteils 1 erfolgt gleichartig wie mit Bezug auf die Figuren 8 und 9 beschrieben, wobei der in Figur 7 dargestellte dritte Schichtverbund 30 verwendet wird.

Es sind neben den in den Figuren 1 bis 3 sowie 7 und 10 dargestellten Ausführungsformen weitere Ausführungsformen des ersten Schichtverbundes 10, des zweiten Schichtverbundes 20 und des dritten Schichtverbundes 30 möglich, sowie verschiedenste Kombinationen dieser Ausführungsformen. Beispielsweise können innerhalb des zweiten Schichtverbundes 20 oder des dritten Schichtverbundes 30 Leiterbahnbrücken, die einzelne elektrisch leitfähige, jedoch physisch voneinander getrennte Bereiche des ersten Schichtverbundes 10 elektrisch leitend miteinander verbinden, oder Elektroden, die ein spezifisches Potential aufweisen und beispielsweise als Detektoren oder Bewegungsbegrenzer dienen können, ausgebildet werden.

Das erfindungsgemäße Verfahren zur Herstellung des Bauteils 1 ermöglicht das Erzeugen einer aktiven Struktur des Bauteils mit zwei getrennten Teilen oder Bereichen, die zwar mechanisch starr miteinander verbunden, aber vollständig elektrisch isoliert voneinander sind.

Des Weiteren kann die Dichtigkeit der hermetischen Verkapselung des aktiven Gebietes des Bauteils 1 sichergestellt werden. Insbesondere können geeignete Fügeparameter während eines Fügeprozesses zur Verbindung des ersten Schichtverbund 10 mit dem zweiten Schichtverbund 20 gewählt werden, da der erste Schichtverbund 10 während des Verbindens mit dem zweiten Schichtverbund 20 eine Dicke, die größer als die Tiefe der gefüllten Gräben 15 ist, und damit eine hohe Stabilität aufweist.

## Patentansprüche

1. Verfahren zum Herstellen eines Bauteils (1), umfassend:
Erzeugen eines ersten Schichtverbundes (10), der eine Strukturschicht (11), die mindestens in einem ersten Bereich (114) elektrisch leitfähig ist, und einen mit einem isolierenden Material gefüllten Graben (15), der sich von einer ersten Oberfläche (111) der Strukturschicht (11) aus erstreckt und in dem ersten Bereich (114) der Strukturschicht (11) angeordnet ist, umfasst, wobei die erste Oberfläche (111) der Strukturschicht (11) einer ersten Oberfläche (110) des ersten Schichtverbundes (10) zugewandt ist,
Erzeugen eines zweiten Schichtverbundes (20), der eine erste Vertiefung (210) in einer ersten Oberfläche (211) des zweiten Schichtverbundes (20) aufweist,
Verbinden des ersten Schichtverbundes (10) mit dem zweiten Schichtverbund (20), wobei die erste Oberfläche (110) des ersten Schichtverbundes (10) zumindest in Bereichen an die erste Oberfläche (211) des zweiten Schichtverbundes (20) angrenzt und wobei der gefüllte Graben (15) innerhalb der lateralen Position der ersten Vertiefung (210) angeordnet wird,
nach dem Verbinden des ersten Schichtverbundes (10) mit dem zweiten Schichtverbund (20) die Dicke des ersten Schichtverbundes (10) von einer zweiten Oberfläche (112) des ersten Schichtverbundes (10) aus bis zur Tiefe des gefüllten Grabens (15) reduziert wird, wobei die zweite Oberfläche (112) des ersten Schichtverbundes (10) der ersten Oberfläche (110) des ersten Schichtverbundes (10) gegenüberliegt,
Erzeugen einer aktiven Struktur (17) des Bauteils (1) in der Strukturschicht (11), wobei die aktive Struktur (17) innerhalb der lateralen Position der ersten Vertiefung (210) angeordnet ist und zwei zweite Bereiche (115) der Strukturschicht (11) umfasst, die im ersten Bereich (114) der Strukturschicht (11) angeordnet, physisch starr miteinander verbunden und durch den gefüllten Graben (15) elektrisch voneinander isoliert sind,
vor dem Verbinden des ersten Schichtverbundes (10) mit dem zweiten Schichtverbund (20) sich der gefüllte Graben (15) im ersten Schichtverbund (10) bis zu einer Tiefe (d₁₅) erstreckt, die kleiner als die Dicke (d₁₀) des ersten Schichtverbundes (10) ist,
**dadurch gekennzeichnet, dass**
der erste Schichtverbund (10) weiterhin eine von der Strukturschicht (11) verschiedene Hilfsschicht (13) umfasst, die gut auf der Strukturschicht (11) haftet, wieder entfernbar ist und an eine zweite Oberfläche (113) der Strukturschicht (11) angrenzt, wobei die zweite Oberfläche (113) der Strukturschicht (11) der ersten Oberfläche (111) der Strukturschicht (11) gegenüberliegt, und
sich der gefüllte Graben (15) bis zur zweiten Oberfläche (113) der Strukturschicht (11) erstreckt.

2. Verfahren zum Herstellen eines Bauteils (1) nach Anspruch 1,
**dadurch gekennzeichnet, dass**
im ersten Schichtverbund (10) vor dem Verbinden des ersten Schichtverbundes (10) mit dem zweiten Schichtverbund (20) neben dem gefüllten Graben (15) keine weiteren Strukturen ausgebildet sind.

3. Verfahren zum Herstellen eines Bauteils (1) nach Anspruch 2,
**dadurch gekennzeichnet, dass**
die aktive Struktur (17) des Bauteils (1) durch Strukturieren der Strukturschicht (11) nach dem Reduzieren der Dicke (d₁₀) des ersten Schichtverbundes (10) bis zur Tiefe (d₁₅) des gefüllten Grabens (15) erzeugt wird.

4. Verfahren zum Herstellen eines Bauteils (1) nach Anspruch 1,
**dadurch gekennzeichnet, dass**
im ersten Schichtverbund (10) vor dem Verbinden des ersten Schichtverbundes (10) mit dem zweiten Schichtverbund (20) neben dem gefüllten Graben (15) nicht mit Material gefüllte Trenngräben (16) ausgebildet sind, wobei sich die Trenngräben von der ersten Oberfläche (110) des ersten Schichtverbundes (10) bis zu einer Tiefe erstrecken, die gleich oder größer als eine Tiefe (d₁₅) des gefüllten Grabens (15) ist, wobei die Trenngräben (16) lateral die aktive Struktur (17) des Bauteils (1) begrenzen.

5. Verfahren zum Herstellen eines Bauteils (1) nach Anspruch 4,
**dadurch gekennzeichnet, dass**
die aktive Struktur (17) des Bauteils (1) durch das Reduzieren der Dicke (d₁₀) des ersten Schichtverbundes (10) bis zur Tiefe (d₁₅) des gefüllten Grabens (15) erzeugt wird.

6. Verfahren zum Herstellen eines Bauteils (1) nach einem der vorherigen Ansprüche,
**dadurch gekennzeichnet, dass**
ein dritter Schichtverbund (30) erzeugt wird, der eine erste Oberfläche (311) des dritten Schichtverbundes (30) aufweist, und
nach dem Erzeugen der aktiven Struktur (17) der erste Schichtverbund (10) mit dem dritten Schichtverbund (30) verbunden wird, wobei die erste Oberfläche (311) des dritten Schichtverbundes (30) zumindest in Bereichen an die zweite Oberfläche (112) des ersten Schichtverbundes (10) angrenzt.

7. Verfahren zum Herstellen eines Bauteils (1) nach Anspruch 6,
**dadurch gekennzeichnet, dass**
vor dem Verbinden des ersten Schichtverbundes (10) mit dem dritten Schichtverbund (30) in der ersten Oberfläche (311) des dritten Schichtverbundes (30) eine zweite Vertiefung (310) erzeugt wird, und
beim Verbinden des ersten Schichtverbundes (10) mit dem dritten Schichtverbund (30) die aktive Struktur (17) innerhalb der lateralen Position der zweiten Vertiefung (310) angeordnet wird.

8. Verfahren zum Herstellen eines Bauteils (1) nach Anspruch 6,
**dadurch gekennzeichnet, dass**
die dem dritten Schichtverbund (30) zugewandte Schicht des ersten Schichtverbundes (10) und die dem ersten Schichtverbund (10) zugewandte Schicht des dritten Schichtverbundes (30) aus dem selben Material bestehen.

9. Verfahren zum Herstellen eines Bauteils (1) nach einem der vorhergehenden Ansprüche,
**dadurch gekennzeichnet, dass**
die dem zweiten Schichtverbund (20) zugewandte Schicht des ersten Schichtverbundes (10) und die dem ersten Schichtverbund (10) zugewandte Schicht des zweiten Schichtverbundes (20) aus dem selben Material bestehen.

## Claims

1. A method for producing a component (1), comprising:
producing a first layer composite (10), which comprises a structured layer (11), which is electrically conductive at least in a first region (114), and a trench (15) filled with an insulating material, which extends from a first surface (111) of the structured layer (11) and is arranged in the first region (114) of the structured layer (11), the first surface (111) of the structured layer (11) facing a first surface (110) of the first layer composite (10),
producing a second layer composite (20), which has a first depression (210) in a first surface (211) of the second layer composite (20),
connecting the first layer composite (10) to the second layer composite (20), the first surface (110) of the first layer composite (10) adjoining the first surface (211) of the second layer composite (20) at least in some regions, and said filled trench (15) being arranged within the lateral position of the first depression (210),
after the first layer composite (10) has been connected to the second layer composite (20), the thickness of the first layer composite (10) is reduced starting from a second surface (112) of the first layer composite (10) to the depth of the filled trench (15), the second surface (112) of the first layer composite (10) lying opposite the first surface (110) of the first layer composite (10),
producing an active structure (17) of the component (1) in the structured layer (11), said active structure (17) being arranged within the lateral position of the first depression (210) and comprising two second regions (115) of the structured layer (11), which are arranged in the first region (114) of the structured layer (11), are physically connected to each other in a rigid manner, and are electrically insulated from each other by means of the filled trench (15),
prior to connecting the first layer composite (10) to the second layer composite (20), the filled trench (15) in the first layer composite (10) extends to a depth (d₁₅), which is smaller than a thickness (d₁₀) of the first layer composite (10),
**characterized in that**
the first layer composite (10) further comprises an auxiliary layer (13) different from the structured layer (11), which adheres well to the structured layer (11), can be removed again, and adjoins a second surface (113) of the structured layer (11), with the second surface (113) of the structured layer (11) lying opposite the first surface (111) of the structured layer (11), and
the filled trench (15) extends to the second surface (113) of the structured layer (11).

2. The method for producing a component (1) according to claim 1,
**characterized in that**
in addition to the filled trench (15), no further structures are formed in the first layer composite (10) prior to connecting the first layer composite (10) to the second layer composite (20).

3. The method for producing a component (1) according to claim 2,
**characterized in that**
the active structure (17) of the component (1) is produced by structuring the structured layer (11), after the thickness (d₁₀) of the first layer composite (10) has been reduced to the depth (d₁₅) of the filled trench (15).

4. The method for producing a component (1) according to claim 1,
**characterized in that**
in addition to the filled trench (15), prior to connecting the first layer composite (10) to the second layer composite (20), dividing trenches (16) not filled with a material are formed in the first layer composite (10), with the dividing trenches extending from the first surface (110) of the first layer composite (10) to a depth, which is equal to or greater than a depth (d₁₅) of the filled trench (15), with the dividing trenches (16) limiting the active structure (17) of the component (1) laterally.

5. The method for producing a component (1) according to claim 4, **characterized in that**
the active structure (17) of the component (1) is produced by reducing the thickness (d₁₀) of the first layer composite (10) to the depth (d₁₅) of the filled trench (15).

6. The method for producing a component (1) according to any one of the preceding claims,
**characterized in that**
a third layer composite (30) is produced, which has a first surface (311) of the third layer composite (30), and that,
after the active structure (17) has been produced, the first layer composite (10) is connected to the third layer composite (30), the first surface (311) of the third layer composite (30) adjoining the second surface (112) of the first layer composite (10) at least in some regions.

7. The method for producing a component (1) according to claim 6,
**characterized in that**
prior to connecting the first layer composite (10) to the third layer composite (30), a second depression (310) is produced in the first surface (311) of the third layer composite (30), and that,
during connecting the first layer composite (10) to the third layer composite (30), the active structure (17) is arranged within the lateral position of the second depression (310).

8. The method for producing a component (1) according to claim 6,
**characterized in that**
the layer of the first layer composite (10) facing the third composite layer (30), and the layer of the third layer composite (30) facing the first composite layer (10) consist of the same material.

9. The method for producing a component (1) according to any one of the preceding claims,
**characterized in that**
the layer of the first layer composite (10) facing the second composite layer (20), and the layer of the second layer composite (20) facing the first composite layer (10) consist of the same material.

## Revendications

1. Procédé pour fabriquer un composant (1), comprenant :
la production d'un premier matériau en couches (10) qui comprend une couche structurée (11) conductrice d'électricité au moins dans une première zone (114), et une tranchée (15), remplie d'un matériau isolant, qui s'étend à partir d'une première surface (111) de ladite couche structurée (11) et qui est disposée dans la première zone (114) de la couche structurée (11), la première surface (111) de la couche structurée (11) étant tournée vers une première surface (110) du premier élément en couches (10),
la production d'un deuxième élément en couches (20) qui présente un premier creux (210) dans une première surface (211) dudit deuxième élément en couches (20),
la liaison entre le premier élément en couches (10) et le deuxième élément en couches (20), la première surface (110) du premier élément en couches (10) étant voisine, au moins dans certaines zones, de la première surface (211) du deuxième élément en couches (20), et la tranchée remplie (15) étant disposée à l'intérieur de la position latérale du premier creux (210),
après la liaison entre le premier élément en couches (10) et le deuxième élément en couches (20), l'épaisseur du premier élément en couches (10) à partir d'une deuxième surface (112) dudit premier élément en couches (10) jusqu'à l'épaisseur de la tranchée remplie (15) étant réduite, la deuxième surface (112) du premier élément en couches (10) étant opposée à la première surface (110) du premier élément en couches (10),
la production d'une structure active (17) du composant (1) dans la couche structurée (11), ladite structure active (17) étant disposée à l'intérieur de la position latérale du premier creux (210) et comprenant deux deuxièmes zones (115) de la couche structurée (11) qui sont disposées dans la première zone (114) de ladite couche structurée (11), qui sont reliées entre elles rigidement, physiquement, et qui sont isolées électriquement les unes des autres par la tranchée remplie (15),
avant la liaison entre le premier élément en couches (10) et le deuxième élément en couches (20), la tranchée remplie (15) prévue dans le premier élément en couches (10) s'étendant jusqu'à une profondeur (d₁₅) qui est inférieure à l'épaisseur (d₁₀) du premier élément en couches (10),
**caractérisé en ce que**
le premier élément en couches (10) comprend également une couche auxiliaire (13), différente de la couche structurée (11), qui adhère bien à cette dernière, qui peut être retirée et qui est voisine d'une deuxième surface (113) de la couche structurée (11), la deuxième surface (113) de la couche structurée (11) étant opposée à la première surface (111) de ladite couche structurée (11), et
la tranchée remplie (15) s'étend jusqu'à la deuxième surface (113) de la couche structurée (11).

2. Procédé pour fabriquer un composant (1) selon la revendication 1, **caractérisé en ce que** dans le premier élément en couches (10), avant sa liaison avec le deuxième élément en couches (20), il n'y aucune autre structure près de la tranchée remplie (15).

3. Procédé pour fabriquer un composant (1) selon la revendication 2, **caractérisé en ce que** la structure active (17) du composant (1) est produite (1) par structuration de la couche structurée (11) après la réduction de l'épaisseur (d₁₀) du premier élément en couches (10) jusqu'à la profondeur (d₁₅) de la tranchée remplie (15).

4. Procédé pour fabriquer un composant (1) selon la revendication 1, **caractérisé en ce que** dans le premier élément en couches (10), avant sa liaison avec le deuxième élément en couches (20), il y a près de la tranchée remplie (15) des tranchées de séparation (16) non remplies de matériau, ces tranchées de séparation s'étendant de la première surface (110) du premier élément en couches (10) jusqu'à une profondeur qui est égale ou supérieure à une profondeur (d₁₅) de la tranchée remplie (15), les tranchées de séparation (16) limitant latéralement la structure active (17) du composant (1).

5. Procédé pour fabriquer un composant (1) selon la revendication 4, **caractérisé en ce que** la structure active (17) du composant (1) est produite par la réduction de l'épaisseur (d₁₀) du premier élément en couches (10) jusqu'à la profondeur (d₁₅) de la tranchée remplie (15).

6. Procédé pour fabriquer un composant (1) selon l'une des revendications précédentes, **caractérisé en ce qu'**un troisième élément en couches (30) est produit, qui présente une première surface (311) dudit élément en couches (30), et
après la production de la structure active (17), le premier élément en couches (10) est relié au troisième élément en couches (30), la première surface (311) du troisième élément en couches (30) étant voisine, au moins dans certaines zones, de la deuxième surface (112) du premier élément en couches (10).

7. Procédé pour fabriquer un composant (1) selon la revendication 6, **caractérisé en ce qu'**avant la liaison entre le premier élément en couches (10) et le troisième élément en couches (30), un deuxième creux (310) est produit dans la première surface (311) du troisième élément en couches (30), et
lors de la liaison entre le premier élément en couches (10) et le troisième élément en couches (30), la structure active (17) est disposée à l'intérieur de la position latérale du deuxième creux (310).

8. Procédé pour fabriquer un composant (1) selon la revendication 6, **caractérisé en ce que** la couche du premier élément en couches (10) qui est tournée vers le troisième élément en couches (30), et la couche du troisième élément en couches (30) qui est tournée vers le premier élément en couches (10) se composent du même matériau.

9. Procédé pour fabriquer un composant (1) selon l'une des revendications précédentes, **caractérisé en ce que** la couche du premier élément en couches (10) qui est tournée vers le deuxième élément en couches (20), et la couche du deuxième élément en couches (20) qui est tournée vers le premier élément en couches (10) se composent du même matériau.
